Europäisches Patentamt

European Patent Office

Office européen des brevets

(11) Publication number: **0 481 093 A1**

# EUROPEAN PATENT APPLICATION
## published in accordance with Art. 158(3) EPC

(21) Application number: 91908785.8

(22) Date of filing: 01.05.91

(86) International application number:
PCT/JP91/00595

(87) International publication number:
WO 91/17602 (14.11.91 91/26)

(51) Int. Cl.5: **H03K 5/13**

(30) Priority: 02.05.90 JP 115204/90

(43) Date of publication of application:
22.04.92 Bulletin 92/17

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **SATOH, Hiroshi**
**3-11-19, Nakamachi**
**Machida-shi, Tokyo 194(JP)**
Inventor: **KAIZUKA, Masao**
**4-40-25, Nakazato, Minami-ku**
**Yokohama-shi, Kanagawa-ken 232(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **DELAY CIRCUIT.**

(57) A delay circuit wherein MOS transistors (21, 22) for resistors for controlling the delay time of a CMOS inverter (26) are inserted between the source of the CMOS inverter (26) and power supply potentials (GND, $V_{dd}$) respectively and the respective sources of the MOS transistors (21, 22) are connected with the power supply potentials (GND, $V_{dd}$) respectively. Therefore, by changing the drain currents of the MOS transistors (21, 22) the control voltages ($V_n$, $V_p$) thereof are changed respectively. The driving capability of the CMOS inverter (26) is consequently changed, allowing the delay time of the inverter (26) to be regulated. Further, since the sources of the MOS transistors (21, 22) are connected with the power supply potentials (fixed potentials) (GND, $V_{dd}$) respectively, the delay time being stable even against disturbance is obtained.

F I G. 3

Technical Field

This invention relates to a delay circuit including a MOSFET and which is used particularly in an analog circuit.

Background Art

In general, an analog-type delay circuit utilizes delay due to LC (L is an inductance and C is a capacitor) or CR (R is a resistance). Especially in an integrated circuit, it is difficult to form inductance L, and therefore delay due to CR is utilized.

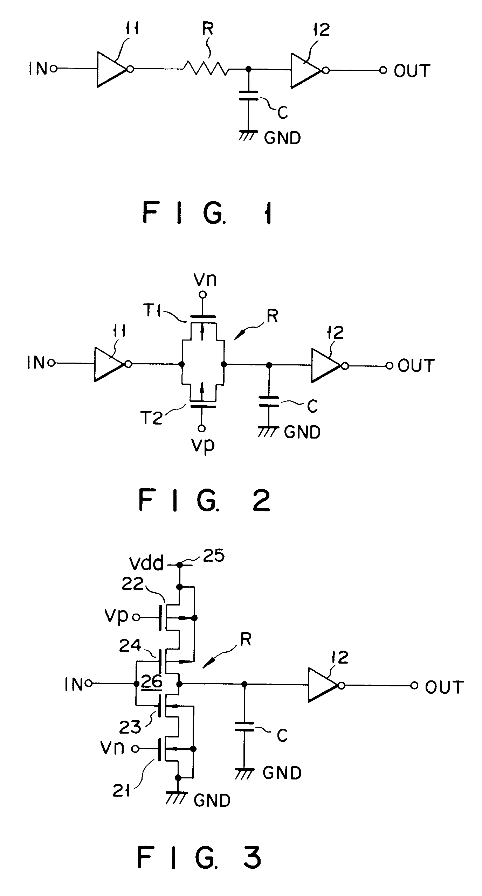

The principle of a delay circuit having such a structure is shown in Fig. 1. In the case of providing this circuit with a variable delay function, the value of capacitor C or resistance R is varied. In an integrated circuit wherein a MOSFET has a variable delay function, resistance R is constituted by a MOSFET. Reference numerals 11 and 12 denote inverters, IN is an input signal, OUT is a delay output, and GND is a ground.

A conventional delay circuit having such a structure is shown in Fig. 2. $T_1$ and $T_2$ are complementary MOSFETs (Metal Oxide Semiconductor Field Effect Transistors) which are used as voltage control type resistances. $V_p$ and $V_n$ are delay control inputs.

However, in a conventional variable delay circuit, the source potentials and drain potentials of an N-type MOSFET (referred to as an N-type MOS transistor) $T_1$ and a P-type MOSFET (referred to as a P-type MOS transistor) $T_2$, which are used as resistances, change in accordance with an input signal IN which passes through these MOS transistors, which causes fluctuation of gate and backgate potentials, varying the resistances of the above MOS transistors dynamically.

Further, when the input signals IN pass through the MOS transistors $T_1$ and $T_2$, interference occurs between each of delay control voltages $V_p$ and $V_n$ and the input signal IN, due to a parasitic capacitance between the channel and gate of each of the MOS transistors $T_1$ and $T_2$, resulting in a delay time influenced by the input signal. In order to eliminate this influence, the driving impedances of the delay control voltages $V_p$ and $V_n$ should be set at small values. However, obtaining a voltage source having a small driving impedance is difficult in terms of manufacturing techniques. In general, a capacitor is used to attain a small impedance. However, there is a limit to the capacitance of the capacitor which can be formed in an integrated circuit, making it difficult to completely eliminate interference between signals.

Disclosure of the Invention

It is therefore the object of the present invention to provide a delay variable type delay circuit wherein a delay time which is stable irrespective of interference between signals can be obtained.

According to the present invention, there is provided a delay circuit which comprises a first N-type MOSFET having a gate to which a first delay time control voltage is applied and a source connected to a low potential power source; a first P-type MOSFET having a gate to which a second delay time control voltage is applied and a source connected to a high potential power source; a second N-type MOSFET having a gate to which an input signal is supplied and a source to which a drain of the first N-type MOSFET is connected; a second P-type MOSFET having a gate and drain which are connected respectively to the gate and drain of the second N-type MOSFET, and a source connected to the drain of the first P-type MOSFET; and a capacitor having two ends, one end being connected to the node between the drain of the second N-type MOSFET and the drain of the second P-type MOSFET, and the other end being connected to one of the low potential power source and the high potential power source. This delay circuit is characterized in that a delay output signal is extracted from the aforementioned one end of the capacitor. Further, according to the present invention, the delay circuit is characterized in that a waveform shaping circuit is connected to one end of the capacitor, and the delay output signal is subjected to waveform shaping in the waveform shaping circuit.

To be specific, according to the present invention, resistance MOSFETs (the first N-type MOSFET and the first P-type MOSFET) for controlling the delay time of a CMOS inverter (constituted by the second N-type MOSFET and the second P-type MOSFET) are inserted between the source and power source of the above CMOS inverter. When the drain currents of the aforementioned resistance MOSFETs are decreased by adjusting the first delay time control voltage and the second delay time control voltage which are mentioned above, the driving capacity of the CMOS inverter is decreased, as a result of which rounding of the waveform of the output from the CMOS inverter is increased, prolonging the delay time of the CMOS inverter. When the drain currents of the resistance MOSFETs are increased, the driving capacity of the CMOS inverter is increased, as a result of which rounding of the waveform of the output from the CMOS inverter is reduced, shortening the delay time of the CMOS inverter. Thus, by changing the first delay time control voltage and the second delay time control voltage, the drain currents of the resistance MOSFETs can be changed, whereby the delay time of the CMOS inverter can be adjusted.

Further, according to the present invention, the sources of the resistance MOSFETs are connected to power sources such that the potentials are fixed. Therefore, there is no influence by disturbances. In order to eliminate rounding, which is used for adjusting the delay time, from the waveform of the output, that output is extracted as a delay output after being subjected to waveform shaping in the waveform shaping circuit. In addition, the resistance MOSFETs are operated in a saturation state.

Brief Description of the Drawings

Fig. 1 is a diagram showing the principle of a delay circuit;

Fig. 2 is a diagram showing a conventional voltage control type delay circuit;

Fig. 3 is a diagram showing the delay circuit according to one embodiment of this invention;

Fig. 4 is a diagram showing a concrete circuit which constitutes a waveform shaping CMOS inverter 12 in the delay circuit shown in Fig. 3; and

Fig. 5 is a diagram showing a modification of the delay circuit shown in Fig. 3.

Description of the Preferred Embodiment

One embodiment of the present invention will now be described with reference to the drawings.

Fig. 3 is the diagram showing the circuit according to the above embodiment. A part of this circuit and the corresponding part of a conventional circuit are denoted by the same reference numeral. As shown in this drawing, a delay time control voltage $V_n$ is applied to the gate of an N-type MOS transistor 21, and the source thereof is connected to a ground GND which is used as a low power source potential $V_{ss}$. A delay time control voltage $V_p$ is applied to the gate of a P-type MOS transistor 22, and the source thereof is connected to a power source terminal 25 which is used as a positive high power source potential $V_{dd}$. An input signal IN is supplied to the gate of an N-type MOS transistor 23, and the source thereof is connected to the drain of the transistor 21. The gate and drain of a P-type MOS transistor 24 are connected respectively to the gate and drain of the transistor 23. The above-mentioned connection results in formation of a resistor circuit R having a CMOS inverter structure. In other words, according to the aforementioned structures, A CMOS inverter is constituted by the MOS transistors 23 and 24. Further, the MOS transistors 21 and 22 form a resistance MOS transistor for controlling the delay time of this CMOS transistor. The output terminal of the resistor circuit R is grounded via a capacitor C. A delay output signal OUT is extracted from the output terminal of the resistor circuit R through a waveform shaping CMOS inverter 12.

In the case of prolonging a delay time in the delay circuit having the aforementioned structures, the control voltages $V_n$ and $V_p$ are decreased and increased, thereby decreasing the drain current which flows through the MOS transistor 22 into the capacitor C and the drain current which flows from the capacitor C through the MOS transistor 21, as a result of which the driving capacity of the CMOS inverter 26 is decreased, increasing the rounding of the waveform of the output therefrom. In the case of shortening the delay time, the control voltages $V_n$ and $V_p$ are increased and decreased, thereby increasing the drain current which flows through the MOS transistor 22 into the capacitor C and the drain current which flows from the capacitor C through the MOS transistor 21, as a result of which the drive capacity of the CMOS inverter 26 is increased, reducing the rounding of the waveform of the output therefrom. In any case, the MOS transistors 21 and 22 are operated in a saturation range.

The output from the resistor circuit R, i.e., the output from the CMOS inverter 26, is input to the waveform shaping CMOS inverter 12 and subjected to waveform shaping so as to eliminate the rounding used for the aforementioned delay, and is thereafter extracted as the delay output OUT.

In the above-mentioned delay circuit, since the source of each of the MOS transistors 21 and 22 is connected to a power source potential, the source potentials of these transistors are not interfered with variations in the potential of the signal IN. Further, since the transistors 21 and 22 are operated in a saturation range, variations in the drain current which occur due to variations in the drain-source voltage are small, with the result that the driving capacity of each of the transistors 23 and 24 can be reliably changed. The input signal IN interferes with the delay control signals $V_n$ and $V_p$ through the gate-drain capacitance of the MOS transistor 21 and the gate-drain capacitance of the MOS transistor 22. Therefore, the amount of interference is smaller than in the conventional circuit shown in Fig. 1, which ensures an improved stabilization of the circuit operation for delaying.

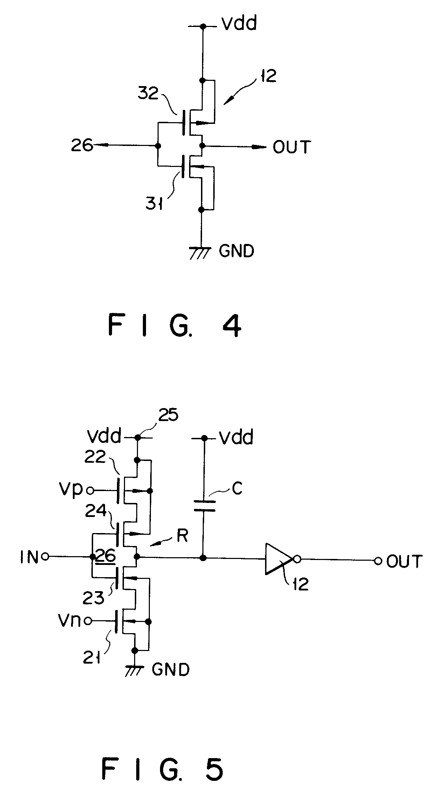

Fig. 4 is a circuit diagram showing a concrete circuit which constitutes the waveform shaping CMOS inverter 12. The CMOS inverter 12 includes an N-type MOS transistor 31 and a P-type MOS transistor 32 which are connected in series between the ground and the high potential power source $V_{dd}$.

The present invention is not limited to the aforementioned embodiment, and various other embodiments can be realized without departing from the scope of this invention. For example, according to the above-mentioned embodiment, the capacitor C is connected to the ground potential. However, it may be connected to the high power source potential $V_{dd}$, as shown in Fig. 5.

Industrial Applicability

The present invention can not only suppress the interference between the input signal and the control signal of the CMOS inverter, but also ensure an operation which is stable irrespective of disturbances. Therefore, the circuit of the present invention is useful when being incorporated into a circuit involving the switching operation which may cause generation of noise.

**Claims**

1. A delay circuit comprising:

   a first N-type MOSFET having a gate to which a first delay time control voltage is applied and a source connected to a low potential power source;

   a first P-type MOSFET having a gate to which a second delay time control voltage is applied and a source connected to a high potential power source;

   a second N-type MOSFET having a gate to which an input signal is supplied and a source to which a drain of the first N-type MOSFET is connected;

   a second P-type MOSFET having a gate and drain which are connected respectively to the gate and drain of the second N-type MOSFET, and a source connected to a drain of the first P-type MOSFET; and

   a capacitor having two ends, one end being connected to a node between a drain of the second N-type MOSFET and the drain of the second P-type MOSFET, and the other end being connected to one of the low potential power source and the high potential power source;

   said delay circuit being characterized in that a delay output signal is extracted from said one end of the capacitor.

2. The delay circuit according to claim 1, characterized in that a waveform shaping circuit is connected to said one end of the capacitor, and said delay output signal is subjected to waveform shaping in the waveform shaping circuit.

F I G. 1

F I G. 2

F I G. 3

F I G. 4

F I G. 5

# INTERNATIONAL SEARCH REPORT

International Application No PCT/JP91/00595

## I. CLASSIFICATION OF SUBJECT MATTER (if several classification symbols apply, indicate all) [6]

According to International Patent Classification (IPC) or to both National Classification and IPC

Int. Cl$^5$ H03K5/13

## II. FIELDS SEARCHED

Minimum Documentation Searched [7]

| Classification System | Classification Symbols |
|---|---|
| IPC | H03K5/04-5/07, H03K5/13-5/145 |

Documentation Searched other than Minimum Documentation
to the Extent that such Documents are Included in the Fields Searched [8]

| | |
|---|---|
| Jitsuyo Shinan Koho | 1926 – 1991 |
| Kokai Jitsuyo Shinan Koho | 1971 – 1991 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| Y | JP, A, 63-146613 (Western Digital Corp.), June 18, 1988 (18. 06. 88), Line 18, upper left column, page 10 to line 4, upper left column, page 11, Figs. 2A to 4 (Family: none) | 1-2 |
| Y | JP, A, 62-214716 (Matsushita Electric Ind. Co., Ltd.), September 21, 1987 (21. 09. 87), Line 2, upper left column to line 12, lower right column, page 3, Figs. 1 to 4 (Family: none) | 1-2 |
| Y | JP, A, 61-39722 (Nippon Gakki Seizo K.K.), February 25, 1986 (25. 02. 86), Line 4, upper right column to line 17, lower right column, page 3, Figs. 1, 8 to 14 & EP, A2, 171022 | 1-2 |
| Y | JP, A, 63-266919 (Hitachi, Ltd.), November 4, 1988 (04. 11. 88), Line 2, upper left column, page 7 to line 10, lower left column, page 9 (Family: none) | 1-2 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure. use. exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| June 20, 1991 (20. 06. 91) | July 1, 1991 (01. 07. 91) |

| International Searching Authority | Signature of Authorized Officer |
|---|---|
| Japanese Patent Office | |

Form PCT ISA 210 (second sheet) (January 1985)